# EUROPEAN PATENT APPLICATION

(11) **EP 2 466 999 A1**
(43) Date of publication of application: **20.06.2012**
(21) Application number: 11192532.7
(22) Date of filing: 08.12.2011
(51) Int. Cl.: H05K 1/02

(54) **Printed circuit board**

(30) Priority: 17.12.2010 JP 2010281484
(71) Applicant: Canon Kabushiki Kaisha, Tokyo 146-8501 (JP)
(72) Inventor: Miyasaka, Jin, Tokyo 146-8501 (JP)
(74) Representative: TBK

(57) **Abstract**

A printed wiring board (101) is formed by laminating a power supply layer (11), a ground lay (12), a first signal wiring layer (13), and a second signal wiring layer (14) with insulating layers respectively interposed therebetween. An IC (111) and an IC (112) are electrically connected to each other by signal wiring via a signal via hole (21). In the printed circuit board, a power supply through-hole (3) electrically connected to the power supply layer and a ground through-hole (4) electrically connected to the ground layer are formed. On the outer layers of the printed wiring board, capacitors (1,2) are mounted, each of which has one end electrically connected to the power supply through-hole and the other end electrically connected to the ground through-hole.

## Description

### BACKGROUND OF THE INVENTION

### Field of the Invention

The present invention relates to a printed circuit board which efficiently reduces power supply impedance around a signal via hole part by saving space and using a small number of parts to ensure a return path of signal current, thereby reducing radiation noise.

### Description of the Related Art

Along with the increase in speed and functionality sophistication of electronic devices in recent years, the increase in frequency of signals transmitted through wiring between circuit devices in printed circuit boards is advanced, and electromagnetic wave noise (radiation noise) emitted from the printed circuit boards is on the increase. The radiation noise may cause a problem of malfunction due to electromagnetic wave interference inside the electronic devices and with other electronic devices.

One factor causing radiation noise is an increase in return path length (loop area formed by signal wiring and a path of return current) in a signal via hole used to change signal wiring layers. In a multi-layer printed circuit board having four or more layers, return current occurs mainly in a conductor layer adjacent to signal wiring. For example, in the case where a conductor layer adjacent to a signal wiring layer is a ground (GND) layer, return current occurs in the ground layer. In the case where signal wiring is formed in multiple layers, a return current path of signal wiring of two layers becomes discontinuous in a signal wiring changing part (signal via hole). This causes detour of the return current, thereby causing radiation noise.

Therefore, in order not to disrupt the return path in the signal via hole, that is, the signal wiring part extending between at least two layers, it is necessary to enhance the connection of the return path of both the layers and shorten the return path length as much as possible.

To deal with this problem, International Publication WO 2004/111890 discloses a printed circuit board in which a capacitor is connected to a power supply plane and a ground plane, and disposed near a signal via hole extending over the power supply plane and the ground plane. The power supply plane and one end of the capacitor are connected to each other via a via hole (power supply through-hole), and the ground plane and the other end of the capacitor are connected to each other via another via hole (ground through-hole).

However, with the above-mentioned structure, it is sometimes the case that desired radiation noise characteristics are not obtained in a high frequency range of 30 MHz and more, which is defined in various noise standards, such as Voluntary Control Council for Interference (VCCI), because the inductance of the power supply through-hole and the ground through-hole is high. In that case, it is preferred, as an inexpensive measure for noise reduction, to dispose an additional capacitor on the printed circuit board. However, the above-mentioned conventional art defines no specific arrangement methods for the case in which multiple capacitors for electrically connecting the power supply plane and the ground plane to each other are required. Simply disposing multiple capacitors leads to the problem of increasing a mounting area due to an increase in number of the power supply through-holes, ground through-holes, and capacitors and the problem of being incapable of efficiently reducing radiation noise due to the inductance of the through-holes.

### SUMMARY OF THE INVENTION

In view of the above-mentioned problems, the present invention aims at providing a printed circuit board which reduces power supply impedance around a signal via hole part to ensure a return path of signal current, thereby reducing radiation noise.

A printed circuit board according to the present invention includes a printed wiring board formed by laminating a power supply layer provided as an inner layer, a ground layer provided as an inner layer, a first signal wiring layer provided adjacent to the ground layer, and a second signal wiring layer provided adjacent to the power supply layer, with insulating layers respectively interposed therebetween. In the printed wiring board, a signal via hole is formed, for electrically connecting first signal wiring provided in the first signal wiring layer and second signal wiring provided in the second signal wiring layer. The printed circuit board further includes: a first capacitor mounted on one outer layer of the printed wiring board; and a second capacitor mounted on another outer layer of the printed wiring board. In the printed wiring board, a power supply through-hole electrically connected to the power supply layer and a ground through-hole electrically connected to the ground layer are formed. One end of each of the first capacitor and the second capacitor is electrically connected to the power supply through-hole, and another end of each of the first capacitor and the second capacitor is electrically connected to the ground through-hole.

According to the present invention, the first capacitor is mounted on one outer layer and the second capacitor is mounted on the other outer layer, and terminals of the capacitors are respectively connected via the same through-holes. Accordingly, the inductance of the power supply through-hole and the ground through-hole is reduced. This results in an improvement in frequency characteristics of the power supply impedance between the power supply layer and the ground layer, with the result of reducing radiation noise.

Further features of the present invention will become apparent from the following description of exemplary embodiments with reference to the attached drawings.

### BRIEF DESCRIPTION OF THE DRAWINGS

FIG. 1 is a perspective view of a printed circuit board according to Embodiment 1.

FIG. 2 is a plan view illustrating capacitor arrangement according to Embodiment 1.

FIGS. 3A, 3B, 3C, and 3D illustrate other configurations according to Embodiment 1.

FIG. 4 is a top view of a circuit board according to Embodiment 2.

FIG. 5 is a top view of a circuit board according to Embodiment 3.

FIG. 6 is a top view of a circuit board according to Embodiment 4.

FIG. 7 is a graph illustrating frequency characteristics of power supply impedance according to Examples.

### DESCRIPTION OF THE EMBODIMENTS

(Embodiment 1)

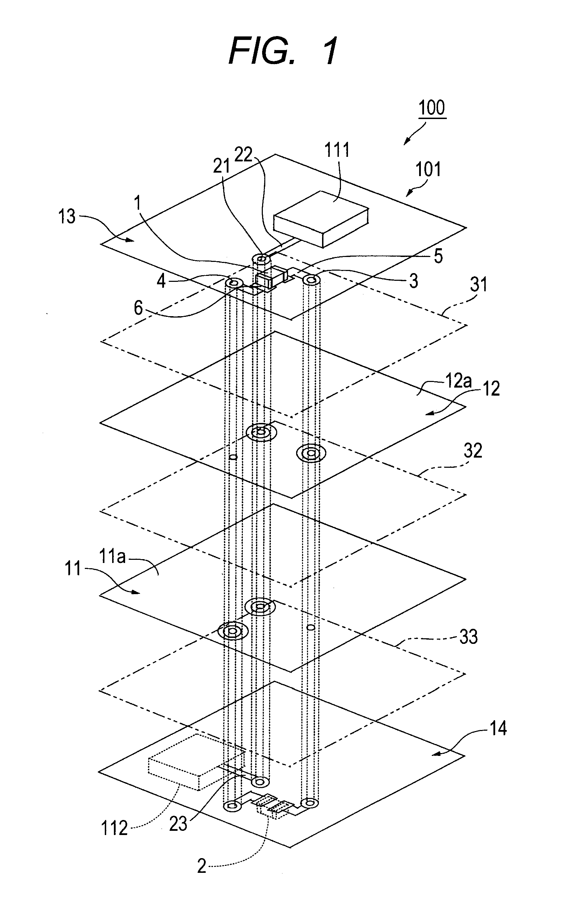

Hereinbelow, embodiments of the present invention are described in detail with reference to the drawings. FIG. 1 is a perspective view of a printed circuit board according to Embodiment 1 of the present invention. A printed circuit board 100 includes a printed wiring board 101, and integrated circuits (ICs) 111 and 112 as semiconductor elements mounted on the printed wiring board 101.

The printed wiring board 101 includes a power supply layer 11 provided with a power plane conductor 11a, a ground layer 12 provided with a ground plane conductor 12a, a first signal wiring layer 13 adjacent to the ground layer 12, and a second signal wiring layer 14 adjacent to the power supply layer 11. Further, the printed wiring board 101 is a four-layer printed wiring board formed by laminating those conductor layers 11, 12, 13, and 14 via insulating layers 31, 32, and 33. In the printed wiring board 101, one outer layer is the first signal wiring layer 13, and the other outer layer is the second signal wiring layer 14. In addition, inner layers disposed on the inner side of the paired outer layers are the power supply layer 11 and the ground layer 12. Further, in the printed wiring board 101, a power supply through-hole 3 electrically connected to the power supply layer 11 and a ground through-hole 4 electrically connected to the ground layer 12 are formed. Each of the through-holes 3 and 4 is a through-hole having a conductor formed on an inner circumference thereof.

Note that, as for the power supply layer of the present invention, the layer thereof does not always need to be entirely made of a power plane conductor, and a ground conductor and signal wiring may be formed in a part of the layer. Similarly, as for the ground layer, the layer thereof does not always need to be entirely made of a ground plane conductor, and a power conductor and signal wiring may be formed in a part of the layer. Similarly, as for the signal wiring layers, each of the layers thereof does not always need to be entirely made of only signal wiring, and a power conductor and a ground conductor may be formed in a part of the layer.

On the first signal wiring layer 13, the IC 111 as a first semiconductor element is mounted, and on the second signal wiring layer 14, the IC 112 as a second semiconductor element is mounted. In addition, in the printed wiring board 101, a signal via hole (signal through-hole) 21 for electrically connecting the ICs 111 and 112 is formed. Specifically, the IC 111 and the signal via hole 21 are electrically connected to each other by first signal wiring 22 provided in the first signal wiring layer 13, and the IC 112 and the signal via hole 21 are electrically connected to each other by second signal wiring 23 provided in the second signal wiring layer 14. That is, the IC 111 is electrically conductive to the first signal wiring 22 by being directly connected to the first signal wiring 22. In addition, the IC 112 is electrically conductive to the second signal wiring 23 by being directly connected to the second signal wiring 23. By means of this, the ICs 111 and 112 are electrically conductive to each other by the signal wiring 22 and 23 via the signal via hole 21.

According to this embodiment, the printed circuit board 100 includes a first capacitor 1, which is mounted on the first signal wiring layer 13, and one end of which is electrically connected to the power supply through-hole 3 and the other end is electrically connected to the ground through-hole 4. Further, the printed circuit board 100 includes a second capacitor 2, which is mounted on the second signal wiring layer 14, and one end of which is electrically connected to the power supply through-hole 3 and the other end is electrically connected to the ground through-hole 4. Note that, in FIG. 1, the IC 112, the second capacitor 2, and the like mounted on the second signal wiring layer 14 are illustrated with a transparent view of the second signal wiring layer 14 for ease in description.

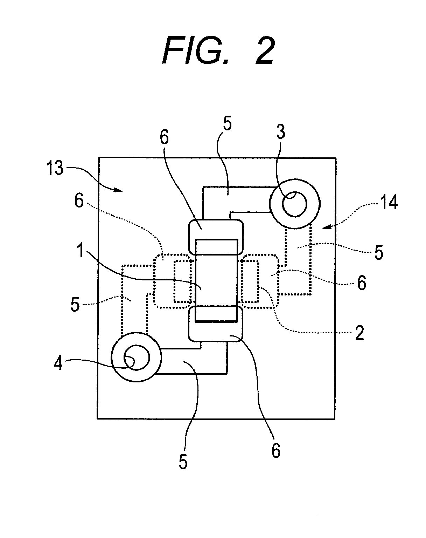

FIG. 2 is a plan view of a part of the printed circuit board, in which the capacitors are disposed, seen from a direction perpendicular to the board plane. In FIG. 2, the power plane conductor 11a of the power supply layer 11 and the ground plane conductor 12a of the ground layer 12 are not shown in order to illustrate only a positional relationship between the first capacitor 1 disposed on one outer layer and the second capacitor 2 disposed on the other outer layer.

As illustrated in FIG. 2, two lands 6 and 6 for mounting the first capacitor 1 thereon are provided on the first signal wiring layer 13. Further, one land 6 of the two lands 6 and 6 is electrically connected to the power supply through-hole 3 with a wiring pattern 5, and the other land 6 is electrically connected to the ground through-hole 4 with the wiring pattern 5. Further, one electrode terminal of the first capacitor 1 is electrically connected to one of the lands 6 and 6 with solder or the like, and the other electrode terminal of the first capacitor 1 is electrically connected to the other land 6 with solder or the like.

Similarly, two lands 6 for mounting the second capacitor 2 thereon are provided on the second signal wiring layer 14. Further, one land 6 of the two lands 6 and 6 is electrically connected to the power supply through-hole 3 with the wiring pattern 5, and the other land 6 is electrically connected to the ground through-hole 4 with the wiring pattern 5. Further, one electrode terminal of the second capacitor 2 is electrically connected to one of the lands 6 and 6 with solder or the like, and the other electrode terminal of the second capacitor 2 is electrically connected to the other land 6 with solder or the like.

Thus, in this embodiment, the first capacitor 1 and the second capacitor 2 are respectively electrically connected to the same power supply through-hole 3 and the same ground through-hole 4. That is, there is no need to provide different power supply through-holes and ground through-holes for the respective capacitors 1 and 2.

By employing the above-mentioned structure, the following two return paths of signal current transmitted between the ICs 111 and 112 via the signal via hole 21 are created. One return path passes through the power supply through-hole 3, then through the first capacitor 1 on one outer layer, and then through the ground through-hole 4. The other return path passes through the power supply through-hole 3, then through the second capacitor 2 on the other outer layer, and then through the ground through-hole 4.

As a result, the inductance of the power supply through-hole 3 and the ground through-hole 4 is about half compared to the case where a capacitor is disposed only on one outer layer, which results in reducing the power supply impedance. This reduces radiation noise emitted from the printed wiring board 101.

In addition, as illustrated in FIG. 1, at least one of the first capacitor 1 and the second capacitor 2 (both the capacitors 1 and 2 according to this embodiment) is disposed adjacent to the signal via hole 21. Here, "the capacitors 1 and 2 being adjacent to the signal via hole 21" refers to a state in which other wiring members and elements except wirings connected to capacitors 1 and 2 are not present between the signal via hole 21 and the capacitors 1 and 2. Thus, by disposing the capacitors 1 and 2 adjacent to the signal via hole 21, the radiation noise can be reduced more effectively.

In addition, with reference to FIG. 2, the capacitors 1 and 2 are disposed in such a manner that, when the first capacitor 1 is projected onto the second signal wiring layer 14 in a perpendicular direction with respect to the board plane on which the conductors of the printed wiring board 101 are disposed, a projection image of the first capacitor 1 overlaps at least a part of the second capacitor 2. That is, the capacitors 1 and 2 are disposed on the signal wiring layers 13 and 14, respectively, in such a manner that the projection image created by projecting the first capacitor 1 onto the second signal wiring layer 14, which is the other outer layer, and the second capacitor 2 at least partially overlap each other.

By employing the above-mentioned structure, the respective capacitors 1 and 2, the power supply through-hole 3, and the ground through-hole 4 are disposed adjacent to each other, which allows the wiring pattern 5 to be shortened. Accordingly, it is possible to reduce a wiring area required for measures against radiation noise, which thus provides space saving. Further, the inductance of the wiring pattern 5 is reduced, thereby enabling an improvement in radiation noise characteristics.

Here, the capacitance values of the capacitors 1 and 2 are determined in view of signal frequencies and rise times of the signal wiring 22 and 23 disposed around the capacitors 1 and 2.

Specifically, according to the following formula (1), impedance Z at a frequency f is approximated using capacitance C and inductance L, and the capacitance values of the capacitors 1 and 2 are determined so as to maintain low impedance in a frequency range (30 MHz and more) of problematic radiation noise.

|Z|≈|1/2πfC-2πfL| Formula (1)

Note that, it is preferred that the positional relationship between the capacitors 1 and 2 be made ideal depending upon wiring conditions around the capacitors on the printed wiring board 101. For example, in the case where the direction of the signal wiring on one outer layer is set orthogonal to the direction of the signal wiring on the other outer layer, it is preferred that the capacitors 1 and 2 be disposed orthogonal to each other, as illustrated in FIG. 2.

In addition, depending on the directions of the signal wiring on both the outer layers, though not illustrated, an ideal positional relationship is that, when the first capacitor is projected in a perpendicular direction with respect to the board plane on which the conductors of the printed wiring board are disposed, the projection image of the first capacitor and the second capacitor entirely overlap each other.

In addition, in the above-mentioned embodiment, the one outer layer does not necessarily refer to a mounting surface for major parts. There are no particular definitions for the one outer layer and the other outer layer, and any one of the outer layers of the printed wiring board may be the one outer layer. In addition, in FIG. 1, the first semiconductor element and the second semiconductor element are disposed on different layers, but may be disposed on the same layer in the case of using two or more signal via holes and two or more sets of signal wiring.

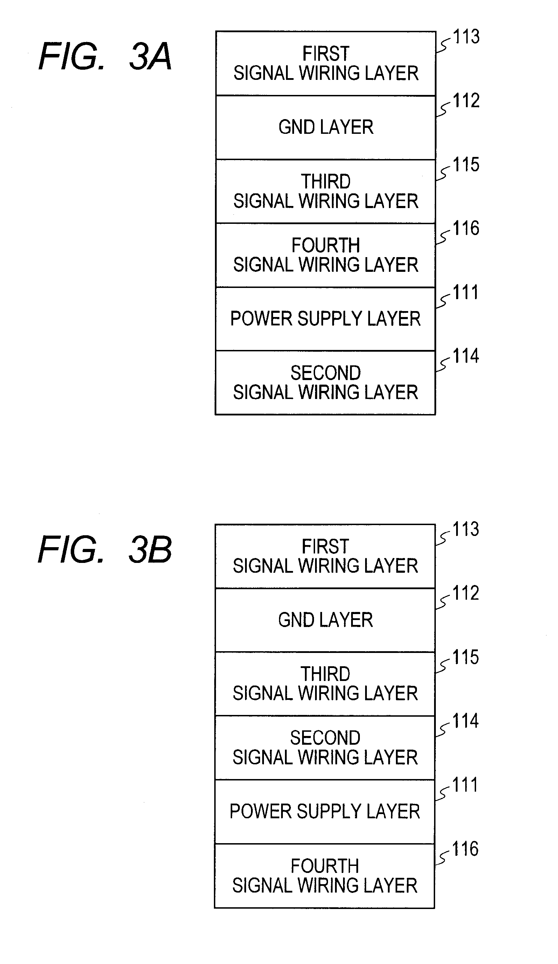

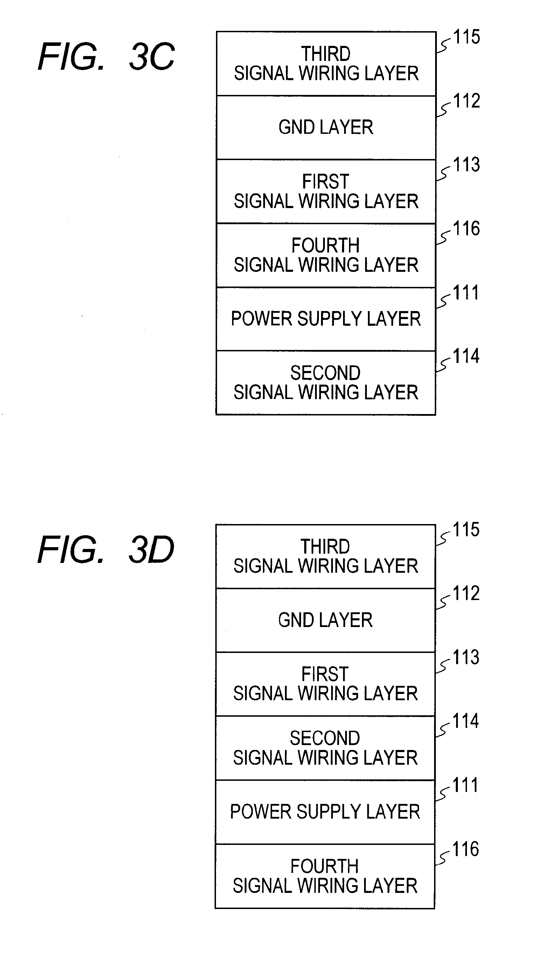

In addition, FIG. 1 illustrates the printed wiring board 101 having a four-layer structure by an example, but the printed wiring board 101 may include five or more layers. In the case of five or more layers, one or both of the first signal wiring and the second signal wiring may be inner layer wiring. For example, in the case of a six-layer printed wiring board, any one of four configurations illustrated in FIGS. 3A, 3B, 3C, and 3D may be used. In FIGS. 3A, 3B, 3C, and 3D, an insulating layer (not shown) is provided between each of the layers. Note that, in the case where one or both of the first signal wiring and the second signal wiring are inner layer wiring, the signal via hole for connecting the first signal wiring layer and the second signal wiring layer to each other may not be a through-hole but a non-through via hole.

FIG. 3A illustrates a multi-layer printed wiring board in which six layers of a first signal wiring layer 113, a ground layer 112, a third signal wiring layer 115, a fourth signal wiring layer 116, a power supply layer 111, and a second signal wiring layer 114 are laminated in the stated order with an insulating layer interposed between each of the layers. In this case, a ground through-hole for connecting the ground layer 112 and a power supply through-hole for connecting the power supply layer 111, respectively, are formed adjacent to a signal via hole (signal through-hole) for connecting the first signal wiring layer 113 and the second signal wiring layer 114.

FIG. 3B illustrates a multi-layer printed wiring board in which six layers of the first signal wiring layer 113, the ground layer 112, the third signal wiring layer 115, the second signal wiring layer 114, the power supply layer 111, and the fourth signal wiring layer 116 are laminated in the stated order with an insulating layer interposed between each of the layers. In this case, a ground through-hole for connecting the ground layer 112 and a power supply through-hole for connecting the power supply layer 111, respectively, are formed adjacent to a signal via hole (signal through-hole) for connecting the first signal wiring layer 113 and the second signal wiring layer 114.

FIG. 3C illustrates a multi-layer printed wiring board in which six layers of the third signal wiring layer 115, the ground layer 112, the first signal wiring layer 113, the fourth signal wiring layer 116, the power supply layer 111, and the second signal wiring layer 114 are laminated in the stated order with an insulating layer interposed between each of the layers. In this case, a ground through-hole for connecting the ground layer 112 and a power supply through-hole for connecting the power supply layer 111, respectively, are formed adjacent to a signal via hole (signal through-hole) for connecting the first signal wiring layer 113 and the second signal wiring layer 114.

FIG. 3D illustrates a multi-layer printed wiring board in which six layers of the third signal wiring layer 115, the ground layer 112, the first signal wiring layer 113, the second signal wiring layer 114, the power supply layer 111, and the fourth signal wiring layer 116 are laminated in the stated order with an insulating layer interposed between each of the layers. In this case, a ground through-hole for connecting the ground layer 112 and a power supply through-hole for connecting the power supply layer 111, respectively, are formed adjacent to a signal via hole (signal through-hole) for connecting the first signal wiring layer 113 and the second signal wiring layer 114.

Note that, regardless of the number of layers of the printed wiring board, the first signal wiring layer 113 is always disposed adjacent to the ground layer 112, and the second signal wiring layer 114 is always disposed adjacent to the power supply layer 111.

In addition, FIG. 1 illustrates separately the wiring patterns, the lands for mounting the capacitors, and the through-holes, but the lands for mounting the capacitors and the through-holes may be integrally formed without providing the wiring patterns extending from the mounting lands to the through-holes.

In addition, in order to minimize antiresonance, it is preferred that the capacitors disposed in pairs on both the outer layers have equivalent capacitance values, and that, one or both of the power supply layer and the ground layer be electrically separated from capacitors having different capacitance values by a resistor, an inductor, and the like.

(Embodiment 2)

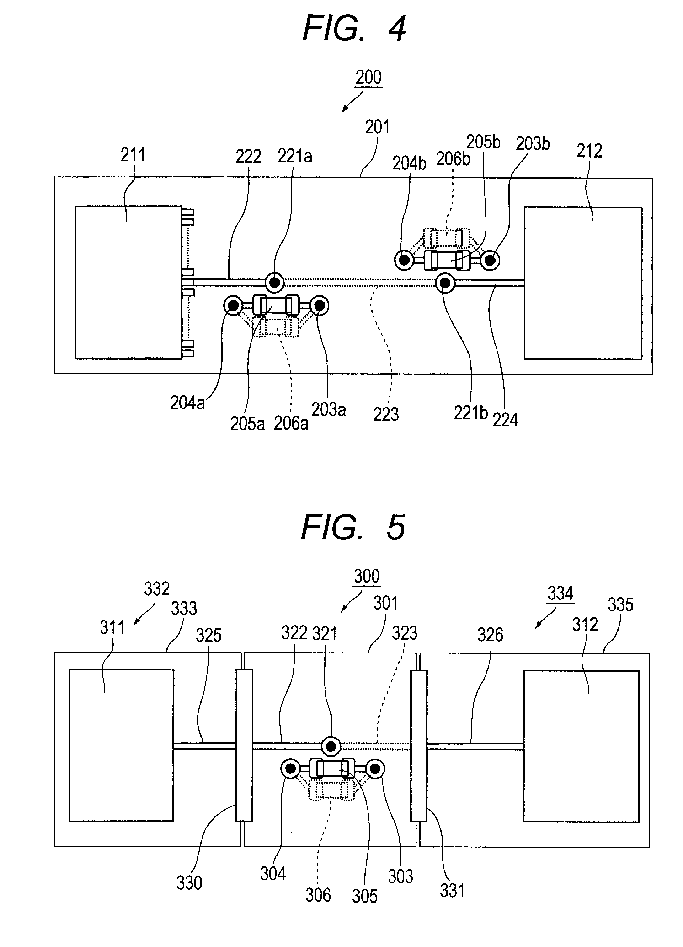

FIG. 4 is a top view of a printed circuit board according to Embodiment 2 of the present invention. A printed circuit board 200 includes a printed wiring board 201, and ICs 211 and 212 as semiconductor elements mounted on the same surface (one outer layer) of the printed wiring board 201. In addition, signal wiring 222, 223, and 224 for electrically connecting the ICs 211 and 212 are connected to each other via two signal via holes 221a and 221b. Adjacent to the signal via hole 221a, a first capacitor 205a and a second capacitor 206a are electrically connected to the same power supply through-hole 203a and the same ground through-hole 204a. In addition, adjacent to the signal via hole 221b, a first capacitor 205b and a second capacitor 206b are electrically connected to the same power supply through-hole 203b and the same ground through-hole 204b.

Thus, the IC 211 is electrically conductive to the signal wiring 222 by being directly connected to the signal wiring 222 and is electrically conductive to the signal wiring 223 by being connected to the signal wiring 223 via the signal wiring 222 and the signal via hole 221a. In addition, the IC 212 is electrically conductive to the signal wiring 224 by being directly connected to the signal wiring 224 and is electrically conductive to the signal wiring 223 by being connected to the signal wiring 223 via the signal wiring 224 and the signal via hole 221b. That is, the ICs 211 and 212 are electrically conductive to each other via the signal wiring 222, the signal via hole (signal through-hole) 221a, the signal wiring 223, the signal via hole (signal through-hole) 221b, and the signal wiring 224.

Here, the IC 211 is referred to as a first semiconductor element, the IC 212 is referred to as a second semiconductor element, and the outer layer on which the ICs 211 and 212 are mounted is referred to as a first signal wiring layer. Further, the signal wiring 222 is referred to as first signal wiring provided in the first signal wiring layer, and the signal wiring 223 is referred to as second signal wiring provided in a second signal wiring layer. In this case, of the two capacitors 205a and 206a disposed adjacent to the signal via hole 221a, a first capacitor mounted on the first signal wiring layer is the capacitor 205a. In addition, a second capacitor mounted on the second signal wiring layer is the capacitor 206a.

On the other hand, the IC 212 is referred to as a first semiconductor element, the IC 211 is referred to as a second semiconductor element, and the outer layer on which the ICs 211 and 212 are mounted is referred to as a first signal wiring layer. Further, the signal wiring 224 is referred to as first signal wiring provided in the first signal wiring layer, and the signal wiring 223 is referred to as second signal wiring provided in a second signal wiring layer. In this case, of the two capacitors 205b and 206b disposed adjacent to the signal via hole 221b, a first capacitor mounted on the first signal wiring layer is the capacitor 205b. In addition, a second capacitor mounted on the second signal wiring layer is the capacitor 206b.

That is, the signal wiring 222, which is the first signal wiring, and the signal wiring 223, which is the second signal wiring, are electrically connected to each other by the signal via hole 221a. Further, adjacent to the signal via hole 221a, the power supply through-hole 203a and the ground through-hole 204a are formed in the printed wiring board 201, and the capacitors 205a and 206a are also mounted on the printed wiring board 201.

Similarly, the signal wiring 224, which is the first signal wiring, and the signal wiring 223, which is the second signal wiring, are electrically connected to each other by the signal via hole 221b. Further, adjacent to the signal via hole 221b, the power supply through-hole 203b and the ground through-hole 204b are formed in the printed wiring board 201, and the capacitors 205b and 206b are also mounted on the printed wiring board 201.

By employing the above-mentioned structure, in a structure where the ICs 211 and 212 are disposed on the same mounting surface in terms of heat resistance and weight and in a structure where the order of the signal wiring is changed with neighboring signal wiring, it is possible to sufficiently reduce power supply impedance, thereby improving radiation noise characteristics.

Note that, although two signal via holes are provided in this embodiment, two or more signal via holes may be provided. Then, adjacent to each of the signal via holes, the power supply through-hole and the ground through-hole are formed in the printed wiring board, and the first capacitor and the second capacitor are mounted on the printed wiring board.

In addition, in FIG. 4, the respective capacitors 205a, 206a, 205b, and 206b are disposed in such a manner that projection images of the capacitors 205a and 205b formed when the capacitors 205a and 205b are projected onto the second signal wiring layer in a perpendicular direction with respect to the plane of the printed wiring board 201 do not overlap the capacitors 206a and 206b, but the present invention is not limited to this case. By disposing the respective capacitors 205a and 206a in such a manner that a part of the projection image of the capacitor 205a overlaps the capacitor 206a, radiation noise is reduced more effectively. In addition, by disposing the respective capacitors 205b and 206b in such a manner that a part of the projection image of the capacitor 205b overlaps the capacitor 206b, radiation noise is reduced more effectively.

(Embodiment 3)

FIG. 5 is a top view of a printed circuit board according to Embodiment 3 of the present invention. To a printed circuit board 300 according to Embodiment 3, printed circuit boards 332 and 334 are connected via connectors 330 and 331, respectively. On a printed wiring board 333 of the printed circuit board 332, an IC 311 as a semiconductor element is mounted, and on a printed wiring board 335 of the printed circuit board 334, an IC 312 as a semiconductor element is mounted. In addition, signal wiring 322, 323, 325, and 326 for electrically connecting the ICs 311 and 312 to each other are electrically connected through the connectors 330 and 331 and a signal via hole (signal through-hole) 321 formed in a printed wiring board 301 of the printed circuit board 300. That is, the signal wiring 322 is the first signal wiring provided in the first signal wiring layer and the signal wiring 323 is the second signal wiring provided in the second signal wiring layer, and the signal wiring 322 and 323 are electrically connected to each other by the signal via hole 321. In addition, adjacent to the signal via hole 321, a first capacitor 305 and a second capacitor 306 are respectively electrically connected to the same power supply through-hole 303 and the same ground through-hole 304. By employing the above-mentioned structure, in a structure which extends over multiple boards because of product specifications, it is possible to sufficiently reduce power supply impedance, thereby improving radiation noise characteristics.

(Embodiment 4)

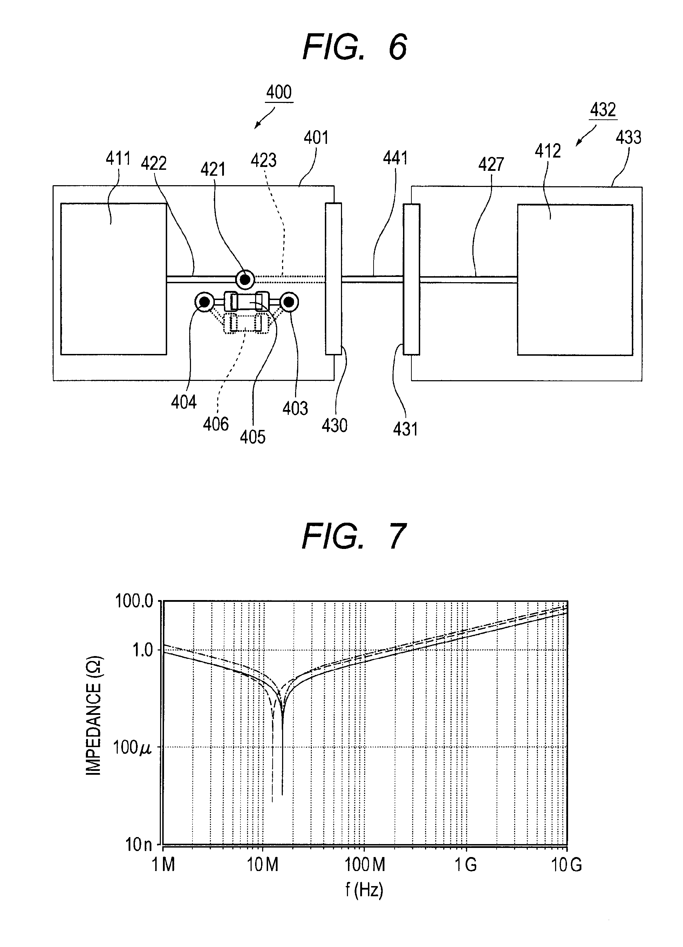

FIG. 6 is a top view of a printed circuit board according to Embodiment 4 of the present invention. To a printed circuit board 400 according to Embodiment 4 of the present invention, a printed circuit board 432 is connected via connectors 430 and 431. On a printed wiring board 401 of the printed circuit board 400, an IC 411 as a semiconductor element is mounted, and on a printed wiring board 433 of the printed circuit board 432, an IC 412 as a semiconductor element is mounted. In addition, signal wiring 422, 423, and 427 for electrically connecting the ICs 411 and 412 to each other are electrically connected through a signal via hole (signal through-hole) 421 disposed in the printed wiring board 401, the connectors 430 and 431, and a signal transmission cable 441. That is, the signal wiring 422 is the first signal wiring provided in the first signal wiring layer and the signal wiring 423 is the second signal wiring provided in the second signal wiring layer, and the signal wiring 422 and 423 are electrically connected to each other by the signal via hole 421. In addition, adjacent to the signal via hole 421, a first capacitor 405 and a second capacitor 406 are respectively electrically connected to the same power supply through-hole 403 and the same ground through-hole 404. By employing the above-mentioned structure, in a structure where the signal transmission cable has an antenna pattern, thereby readily causing radiation noise, it is possible to sufficiently reduce power supply impedance, with the result of improving radiation noise characteristics.

(Example 1)

Example 1 of the present invention is described. With the structure of the printed circuit board 100 illustrated in FIG. 1, conditions of the printed circuit board 100 were designed as follows. The thickness of the printed wiring board was 1.6 mm. The hole diameter of the power supply through-hole 3 and the ground through-hole 4 was 0.4 mm, and the land diameter was 0.8 mm. For each of the first capacitor 1 and the second capacitor 2, a chip of 1005 size having a capacitance value of 0.1 µF was used. The adjacent distance between the first capacitor 1 and the signal via hole 21 was 0.735 mm. Note that, the equivalent series inductance (ESL) of the capacitors 1 and 2 was 0.45 nH.

Under those conditions, the inductance of the power supply through-hole 3 was 0.43 nH between the one outer layer and the power supply layer and 0.17 nH between the other outer layer and the power supply layer. In addition, the inductance of the ground through-hole 4 was 0.17 nH between the one outer layer and the ground layer and 0.43 nH between the other outer layer and the ground layer. The power supply impedance characteristics under those conditions are indicated by the solid line in FIG. 7.

(Comparative Example 1)

Comparative Example 1 was a four-layer printed circuit board as in Example 1, and although the first capacitor was disposed on the first signal wiring layer, the second capacitor was not disposed on the second signal wiring layer. Accordingly, in Comparative Example 1, the following components present in Example 1 were not provided, the second capacitor of the second signal wiring layer, the wiring connecting the power supply through-hole and the second capacitor, and the wiring connecting the ground through-hole and the second capacitor. Except for those, the structure and configuration are the same as those in Example 1. The power supply impedance characteristics under those conditions are indicated by the broken line in FIG. 7.

(Comparative Example 2)

Comparative Example 2 was a four-layer printed circuit board as in Example 1, and although the first capacitor was disposed on the first signal wiring layer, the second capacitor was not disposed on the second signal wiring layer. Further, another capacitor having the same capacitance value as that of the first capacitor is connected in parallel to the first capacitor on the first signal wiring layer. Accordingly, in Comparative Example 2, the following components present in Example 1 were not provided, the second capacitor of the second signal wiring layer, the wiring connecting the power supply through-hole and the second capacitor, and the wiring connecting the ground through-hole and the second capacitor. Except for those, the structure and configuration are the same as those in Example 1. The power supply impedance characteristics under those conditions are indicated by the dashed and dotted line in FIG. 7.

FIG. 7 enables to compare how frequency characteristics of the power supply impedance may vary depending on capacitor arrangement methods in the case where one power supply through-hole and one ground through-hole are provided. As described above, in the case where the capacitors 1 and 2 are disposed as in Example 1, the inductance of the power supply through-hole 3 and the ground through-hole 4 appears about half compared to the case of Comparative Example 1.

However, in the case of the conventional capacitor arrangement method, only one path for the return current flowing through the power supply through-hole and the ground through-hole is formed, which passes through the power supply through-hole, through the capacitor of the one outer layer, and then through the ground through-hole. As a result, the inductance of the power supply through-hole and the ground through-hole is about twice compared to the case where the capacitors are arranged based on the structure of Example 1. Accordingly, when the frequency characteristics of the power supply impedance are compared, in a high frequency range where the inductance is dominant, the lowest impedance is achieved with the capacitor arrangement based on the structure of Example 1.

In general, when power supply impedance is low, a strong connection between the power and ground is found, which facilitates the signal return current to move between the power supply layer and the ground layer. As a result, the length of the return path, which is formed at the time of change in wiring layers of signal wiring, tends to be short. Consequently, it is possible to suppress unnecessary electromagnetic waves emitted due to a long return path. Particularly, the effect on a signal having a frequency of 30 MHz or more is evident.

In addition, according to the capacitor arrangement methods of Comparative Examples 1 and 2, the power supply through-hole and the ground through-hole respectively have open ends in the second signal wiring layer on which no capacitor is disposed. Accordingly, current flowing from a through-hole to an open end undergoes total reflection at the open end, and then returns to the power supply layer or the ground layer. This causes the current flowing to the power supply or ground to be amplified, as radiation noise, by frequency components of a standing wave which predominantly has one-quarter wavelength of a path, in a corresponding through-hole, extending from the power supply layer and the ground layer to the open end on the other outer layer. According to the structure of Example 1, a capacitor is mounted at the ends of the through-holes, which are open ends in Comparative Examples 1 and 2 described above. This structure has no open end in a high-frequency component, therefore achieving a structure for preventing the occurrence of the above-mentioned standing wave. As a result, it is possible to suppress unnecessary electromagnetic waves emitted due to the open ends of the through-holes.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.
A printed wiring board is formed by laminating a power supply layer, a ground layer, a first signal wiring layer, and a second signal wiring layer with insulating layers respectively interposed therebetween. An IC and an IC are electrically connected to each other by signal wiring via a signal via hole. In the printed circuit board, a power supply through-hole electrically connected to the power supply layer and a ground through-hole electrically connected to the ground layer are formed. On the outer layers of the printed wiring board, capacitors are mounted, each of which has one end electrically connected to the power supply through-hole and the other end electrically connected to the ground through-hole.

## Claims

1. A printed circuit board (100), comprising:
a printed wiring board (101) comprising:
multiple conductor layers laminated with insulating layers (31, 32, 33) respectively interposed between each of the multiple conductor layers,
the multiple conductor layers comprising:
a power supply layer (11) provided as an inner layer;
a ground layer (12) provided as an inner layer;
a first signal wiring layer (13) provided adjacent to the ground layer; and
a second signal wiring layer (14) provided adjacent to the power supply layer;
first signal wiring (22) provided in the first signal wiring layer;
second signal wiring (23) provided in the second signal wiring layer; and
a signal via hole (21) for electrically connecting the first signal wiring and the second signal wiring to each other;
a first capacitor (1) mounted on one outer layer of the printed wiring board;
a second capacitor (2) mounted on another outer layer of the printed wiring board;
a power supply through-hole (3) electrically connected to the power supply layer; and
a ground through-hole (4) electrically connected to the ground layer,
wherein one end of each of the first capacitor and the second capacitor is electrically connected to the power supply through-hole, and another end of the each of the first capacitor and the second capacitor is electrically connected to the ground through-hole.

2. The printed circuit board according to claim 1, wherein the first signal wiring layer is the one outer layer and the second signal wiring layer is the another outer layer.

3. The printed circuit board according to claim 1, wherein one or both of the first signal wiring layer and the second signal wiring layer are respectively formed as an inner layer of the printed wiring board.

4. The printed circuit board according to any one of claims 1 to 3, wherein at least one of the first capacitor and the second capacitor is disposed adjacent to the signal via hole.

5. The printed circuit board according to any one of claims 1 to 4, wherein the first capacitor and the second capacitor are disposed in such a manner that a projection image of the first capacitor formed by projecting the first capacitor onto the another outer layer in a perpendicular direction with respect to a plane of the printed wiring board overlaps at least a part of the second capacitor.

6. The printed circuit board according to claim 1 to 5, further comprising:
a first semiconductor element mounted on the one outer layer so as to be electrically conductive to the first signal wiring; and
a second semiconductor element mounted on the another outer layer so as to be electrically conductive to the second signal wiring.

7. The printed circuit board according to claim 1 to 5, further comprising:
a first semiconductor element mounted on the one outer layer so as to be electrically conductive to the first signal wiring; and
a second semiconductor element mounted on the one outer layer so as to be electrically conductive to the second signal wiring.
